(19) Europäisches Patentamt

European Patent Office

Office européen des brevets

(11) EP 0 604 037 B1

(12) **EUROPEAN PATENT SPECIFICATION**

(45) Date of publication and mention
of the grant of the patent:
**08.07.1998 Bulletin 1998/28**

(51) Int Cl.⁶: **H02H 7/22**

(21) Application number: **93309660.4**

(22) Date of filing: **02.12.1993**

(54) **Busbar protection method**

Verfahren zum Schutz einer Sammelschiene

Procédé de protection de barre collectrice

(84) Designated Contracting States:
**DE FR GB**

(30) Priority: **04.12.1992 JP 325569/92**
**27.04.1993 JP 99996/93**

(43) Date of publication of application:
**29.06.1994 Bulletin 1994/26**

(73) Proprietor: **FUJI ELECTRIC CO. LTD.**
**Kawasaki 210 (JP)**

(72) Inventor: **Suzuki, Isamu, c/o Fuji Electric Co., Ltd.**
**Kawasaki (JP)**

(74) Representative: **Bridge-Butler, Alan James et al**
**G.F. Redfern & Co.,**
**7 Staple Inn,**
**Holborn**
**London WC1V 7QF (GB)**

(56) References cited:
EP-A- 0 109 629          EP-A- 0 400 230
DD-A- 257 332            DD-A- 275 144
DE-A- 2 413 399          DE-A- 3 122 109

• ETZ ELEKTROTECHNISCHE ZEITSCHRIFT,
vol.111, no.18, September 1990, BERLIN, DE
pages 924 - 929 DILLMANN ET AL.
'Online-Untersuchungen von Störfällen in
elektrischen Netzen'

## Description

The present invention relates to electrical and electronic circuitry, and particularly concerns a busbar protection method which, in order to protect a busbar, makes it possible to detect a fault on a busbar of a transmission and distribution system, and to localise the faulty point to a specific section of the busbar.

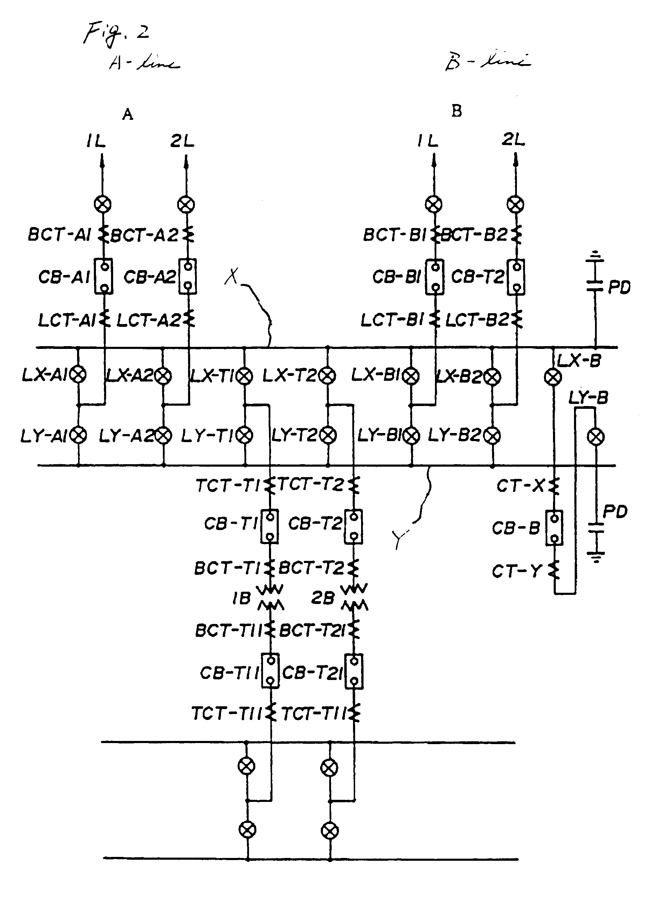

A part of a single line diagram in a conventional substation illustrating the high voltage side of the busbars in detail is seen in Figure 2. The detail of the low voltage busbars, which are connected to the low voltage side of the transformers 1B and 2B, is omitted in this Figure.

There are two busbars X and Y, and interlink lines, which are configured to interlink both X and Y busbars. The transformers 1B and 2B as well as the transmission lines A and B are connected to the interlink lines and further to the X and Y busbars via line switches LX- and LY-, which serve to selectively connect the transformers and transmission lines to either of the X and Y busbars. The line switches LX- and LY- are generally called isolators. In many cases, additional apparatus not illustrated in the Figure are also connected to the duplicated busbar in the same way. References in the Figure include the letter L to designate the line switch, the letters CB for the circuit breaker, the letters BCT for the current transformer of the line side, the letters LCT for the current transformer of the busbar side, the letters TCT for the current transformer of the transformer, the letter X for the X busbar, and the letter Y for the Y busbar. In the references, symbols following a hyphen designate the location where the apparatus is installed. However, omission of the characters following a hyphen such as the reference LX- designates generally the character of the apparatus and not the location where the apparatus is installed.

The lines A-1L, A-2L, B-1L and B-2L as well as the transformers 1B and 2B are connected to the duplicated busbar via the circuit breakers CB-. The current transformers LCT- and BCT- are installed on both sides of the circuit breakers CB-. The current transformers LCT- connected to the busbar side serve to protect the lines or the apparatus such as transformers, and the current transformers BCT- connected to the line or the additional apparatus serve to protect the busbar. In other cases, the current transformers LCT- and BCT- are collectively connected to the busbars, the lines or the additional apparatus. In these cases, the current transformers which are installed near the busbar are designated as LCT-, and those connected to the apparatus are designated as BCT-. As shown in the Figure, another interlink line which interlinks both of the busbars comprises a circuit breaker CB-B, the LX-B and LY-B as well as the CT-X and CT-Y.

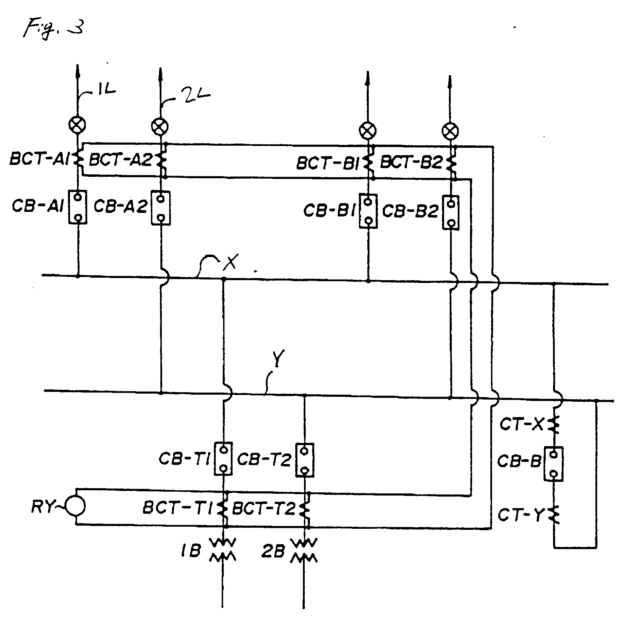

Lines such as transmission lines and apparatus such as transformers are connected in general to the duplicated busbar so as to equalise load on both of the busbars as far as possible. If the line 1L is connected to the X busbar, for instance as shown in the following Figure 3, then the line 2L is connected to the Y busbar. As a result, the current flowing through the circuit breaker CB-B which interlinks both of the busbars is nearly zero.

The known protection method for the duplicated busbar system is as described in the following.

Figure 3 illustrates the principle of a collective protection method of the duplicated busbar. In this Figure, all of the secondary circuits of the current transformers BCT- installed in the lines or in the apparatus such as transformers are connected in parallel and a detecting relay RY is also connected in parallel to the circuit thereof. Consequently, the sum total of the detected current of all of the current transformers BCT- flows through the relay RY.

Therefore, if the fault has occurred elsewhere than in the busbar on the outside of which the current transformers BCT are installed, the current flowing through the relay RY is zero. However, if the fault has occurred elsewhere, a current corresponding to that flowing into the faulty point flows through the relay RY. In order to detect the fault on the busbar, the relay RY is actuated, when the foregoing current flowing through the relay exceeds the predetermined threshold by means of which errors of the current transformer are taken into account.

In many cases, the fault on the duplicated busbar occurs on either side of the X busbar or the Y busbar, but in a few cases simultaneously on both sides of the two busbars. Accordingly, it is desirable to detect the fault and identify whether it is the X busbar or of the Y busbar is faulty.

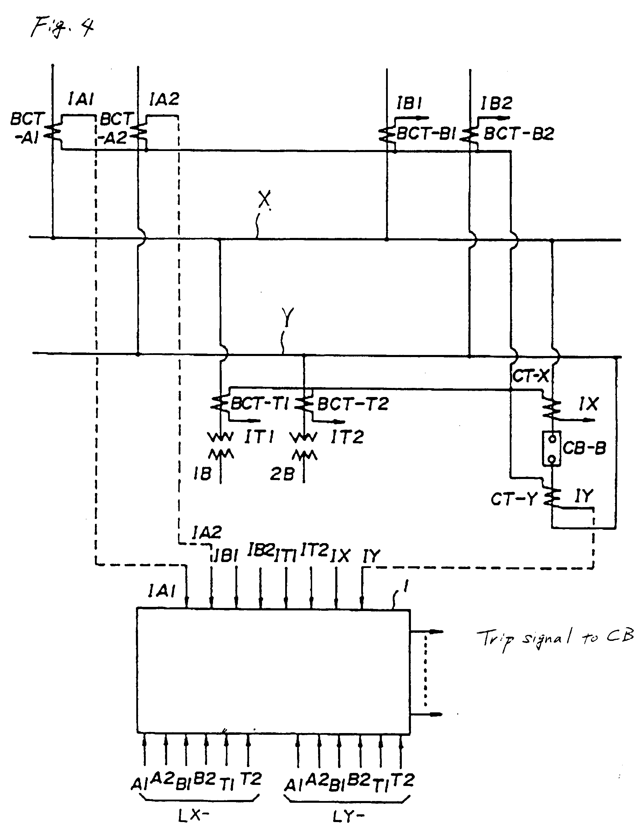

In order to provide continuity of the electrical power supply, it is more advantageous to isolate the faulty busbar and to keep the sound busbar live than to collectively isolate both of the busbars. With reference to Figure 4, a method of distinguishing the faulty busbar from the sound busbar is described in the following.

As is seen in Figure 4, data from circuit elements is provided to a busbar protection device 1. The data comprises the current signals emanating from the current transformers BCT-, which are installed in the lines, apparatus etc; the current signals emanating from the current transformers BCT- interlinking the busbars; and the output signals indicating the switching state of the line switches LX- and LY-, i.e. "open" or "closed" signals.

A digital processor 1 is built in the busbar protection device. The above mentioned input signals are sampled by the digital processing device with a certain period, and, on the basis of the data thereof, digital computing is then performed according to the following calculations.

Not only an instantaneous value of the current but also a value vectorically synthesised from the effective value of the currents is available in this calculation.

In this Figure, the current of a single phase is expressed. However, three phase currents are handled in practical cases.

ΣI (the secondary currents of the current transformers which are closed in the LX- side) > K--------(1)
ΣI (the secondary currents of the current transformers which are closed in the LY- side) > K--------(2)
ΣI (the secondary currents of the current transformers other than IX and IY) > K --------------(3)

where Σ designates a sum total of the currents I, and K designates a predetermined threshold value.

If the inequality (1) is satisfied, i.e. if I is greater than the threshold value K, then this indicates that the fault has occurred on the X busbar. Likewise, the inequality (2) indicates that the fault has occurred on the Y busbar, and the inequality (3) indicates that the fault has occurred somewhere on the busbars without the faulty busbar (the X busbar or the Y busbar) being identified.

Therefore, a trip command to the circuit breaker CB- is emitted from the busbar protection equipment 1, according to the following conditions:

(a) The trip command for the circuit breakers connected to the X busbar is to be based on "(3)^(1)".
(b) The trip command for the circuit breakers connected to the Y busbar is to be based on "(3)^(2)".
(c) The trip command for all of the circuit breakers is to be based on "(3)^(2)(-)^(1)(-)".

where the symbol ^ designates the logical product "and", and (1)(-) and (2)(-) respectively designate situations wherein the inequalities (1) and (2) are not satisfied. In other words, "(3)^(1)" means that both inequalities (3) and (1) are satisfied, i.e. that the sum of the secondary currents of the LX side current transformers exceeds the threshold value K, and simultaneously the sum of secondary currents in current transformers other than IX and IY also exceeds the threshold value K.

In practice, in order to keep the apparatus safe, conditions are added to the foregoing logical product "and". These conditions are imposed over the logic steps already described and include the detection of a voltage fall in the faulty phase, a zero-sequence voltage generated due to the line-to-ground fault, or an overcurrent in the busbar interlink.

However it is not possible to detect the location where the fault has occurred using the aforementioned method of fault detection and protection on a unit of the busbar basis. Therefore, this method provides no proper protection and this has been an ongoing problem.

EP-A-0 400 230 describes a system for detecting a fault within a substation in which at least one input line and a plurality of busbar disconnecting switches are connected in circuit portions connecting the input line and output lines with each other. The system uses a plurality of optical current sensors to detect current flows in the lines and fault location detecting means using information from the current sensors to determine if a fault condition exists.

The object of the present invention is to eliminate the foregoing problems associated with conventional busbar protection methods.

According to the present invention there is provided a method of detecting and localising a fault in a busbar (X,Y) to which a plurality of lines or apparatus (A,B) is connected, on the basis of the currents detected by a current detector (BCT) installed in the busbar and respective ones installed in the lines or apparatus, characterised in that said method comprises the steps of; a) computing a first value of current flowing at the junction of the line and the busbar using the current detected by the current detector installed in the busbar (CT); b) computing a second value of the current at the junction of the line and the busbar from the currents detected by the current detectors installed in the lines; c) calculating the difference of the first and second computed values; d) comparing the difference with a predetermined threshold value; and e) determining that a fault exists at the point if the difference exceeds the threshold value.

Further, a second aspect of the present invention is characterised in a method of protecting a busbar, wherein, in protecting a busbar by judging whether a fault has occurred or not, on the basis of the current detected by the current detectors installed in the busbar and at least in two lines or apparatus connected thereto, a line or apparatus is designated as A, another line or apparatus is designated as B, a connection point of the line or apparatus A to the busbar is designated as A1 and a second connection point of the line or apparatus B to the busbar is designated as B1, and on the basis of the currents detected by the foregoing detectors, computing the difference of the current flowing out from the connection point A1 toward the connection point B1 and the current flowing into the connection point B1 from the direction of the connection point A1, it is consequently judged in particular that, if the foregoing current exceeds a predetermined value, the fault has occurred on the section between the connection points A1 and B1.

And further, a third aspect of the present invention is characterised in the method of protecting a busbar, wherein, in protecting a busbar by judging whether a fault has occurred or not, on the basis of the current detected by the current detectors installed in the busbar and at least two lines or apparatus connected thereto, a line or apparatus is designated as A, another line or apparatus neighbouring thereto is designated as B, a connection point of the line or apparatus A to the busbar is designated as A1 and a second connection point of the line or apparatus B to the busbar is designated as B1, and further the location of a current detector installed in the line or apparatus A is designated as A2, the current of the line A is computed from the currents detected by the current detectors excluding the current detector of the location A2, the difference of the current in line A and the current detected by the current detector of the location A2 is computed, the foregoing first current difference not exceeding a predetermined value, computing a second current difference between the current flowing out from the connection point A1 toward the connection point B1 and the current flowing into the connection point B1 from the direction of the connection point A1, the second current difference not exceeding a predetermined value, and by computing the operational sum of the currents flowing into or flowing out from the busbar excluding the end of the busbar, it is consequently judged in particular that, if the foregoing current sum exceeds a predetermined value, the fault has occurred on the end section of the busbar.

The present invention is characterised in the method of protecting a busbar, wherein the busbar belongs to a duplicated busbar system to each busbar of which a line or apparatus is connected via a line switch, and it is possible to select for computing the current value of the current detectors according to the information on the switching state of the line switches, or wherein the busbar belongs to a single busbar system.

The present invention is characterised in the method of protecting the duplicated busbar system, wherein designating two busbars as X busbar and Y busbar, designating a line or apparatus connected to the connection point S, to which the X busbar and the Y busbar are also connected via a line switch LX-A and a line switch LY-A respectively, as line or apparatus A, and then the line switch LX-A being closed and the line LY-A being open, computing the current flowing through the line switch LX-A from the current detected by the current detector, computing the difference of the above current and the current detected by the current detector installed in the line or apparatus A, it is consequently judged in particular that, if the foregoing current difference exceeds a predetermined value, the fault has occurred on the section between the connection point S and the line switch LY-A.

If a fault has occurred on the section between current transformers and the connection point thereof to the busbar (the first section), or on the busbar section between the neighbouring line outlets (the second section), the resulting fault current is expressed as an operational sum of the output current of each current transformer, that is, of the observable values. The current computed as the operational sum is zero in normal conditions where no fault occurs on the busbar, but, in the case of a fault, reaches a definite value other than zero. Noticing this point, it is possible to detect the fault, localising the faulty point to the specific section. If the currents of the first and second sections are zero, but the current sum exceeds a predetermined threshold, then it is judged that the fault has occurred on the end section of the busbar.

The invention will now be described in detail with reference to the accompanying drawings in which:

Figure 1 illustrates the principle of the present invention;
Figure 2 is a view of part of a single line diagram of a conventional substation in general;
Figure 3 is a schematic view of the collective detection and protection method;
Figure 4 is a schematic diagram of the sectional protection method; and
Figure 5 is a detailed diagram showing a part of Figure 2.

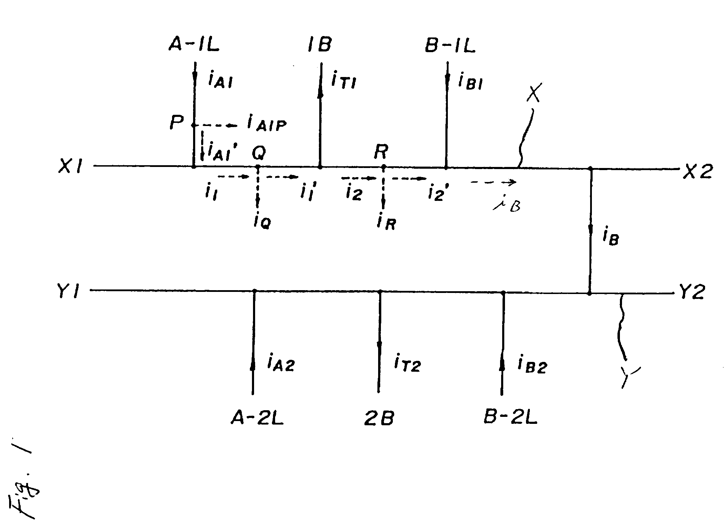

Referring to Figure 1, to describe the principle of the present invention more abstractly than Figure 4, it can be seen that the current $i_{A1}$ in Figure 1 corresponds to the current IA1, and currents $i_{A2}$, $i_B$, $i_{B1}$, $i_{B2}$, $i_{T1}$, $i_{T2}$ also correspond to currents IA2, IB, etc, respectively. For detecting each current value, any type of current detector may be used including, but not limited to, the current transformer (CT).

Since the current in Figure 1 is detected by the current transformers BCT-, it is judged in Figure 2 that, in the case of a fault on the X busbar, it has occurred on the busbar between the X busbar side of the BCT- and the X busbar side of the CT-X, and that, in the case of a fault on the Y busbar, it has occurred on the busbar between the Y busbar side of the BCT- and the Y busbar side of the CT-Y. However, if observed in detail, sections of the faulty busbar can be classified in the following three categories.

(1) A section between the BCT- and the connection points to the busbar of the line or of the apparatus in which the BCT- is installed.
(2) A section between the connection points to the busbar of the neighbouring lines or of the neighbouring apparatus.
(3) A section between the busbar end and the neighbouring connection point thereof (4 sections at X1, X2, Y1 and Y2).

According to the conventional busbar protection method, a fault which has occurred on either of the foregoing sections is collectively dealt with as the fault on the X busbar or on the Y busbar.

However, the preferred embodiments make it possible to discriminate between the above 3 categories. Moreover, in category (1) or (2), the specific section among those ones can be identified. Each category is described in detail as the following:

Category (1)

Assuming in Figure 1 that a fault has occurred at the point P and a fault current $i_{A1P}$ flows, it is possible to detect the fault at the point P, if the foregoing current $i_{A1P}$ can be expressed in terms of the observable (measurable) currents $i_{A1}$, $i_{A2}$, $i_{B1}$, $i_{B2}$, $i_{T1}$, $i_{T2}$ and $i_{B}$.

Assuming thus a current illustrated with a dotted line in Figure 1, the current can be expressed as:

$$i_{A1}' = i_{T1} + i_{B} - i_{B1} \qquad (4)$$

Thus,

$$i_{A1P} = i_{A1}' - i_{A1} = i_{T1} + i_{B} - i_{B1} - i_{A1} \qquad (5)$$

The current $i_{A1P}$ is equal to zero, when no fault occurs. Accordingly, if the current $i_{A1P}$ is not zero, this indicates that the fault has occurred at the point P.

The present invention sets a predetermined threshold K against the current $i_{A1P}$ at the point P, which is expressed as the operations of the observable values.

According to the present method, if,

$$i_{A1P} > K$$

then it is judged that the fault has occurred on the section between the connection point of the line A-1L to the X busbar and the current transformer BCT-A1 by which the current $i_{A1}$ is detected.

As for the point P, this may be anywhere between the connection point to the busbar and the current transformer BCT-A1. This holds also between the connection point to the busbar and the current transformer BCT-A2, BCT-B1, BCT-B2, BCT-T1 and BCT-T2.

Category (2)

The aforementioned logic can be applied to faults occurring at the points Q and R located between the neighbouring line outlets. In other words, in the case of the point Q as shown in Figure 1, the currents, $i_1$ and $i_1'$ are expressed as:

$$i_1 = i_{A1}$$

$$i_1' = i_{T1} + i_{B} - i_{B1}$$

Therefore, the current flowing through the point Q is expressed as :

$$i_Q = i_1' - i_1 = i_{T1} + i_{B} - i_{B1} - i_{A1} \qquad (7)$$

In the same way, the current $i_R$ expressed $i_2$, $i_2'$ flowing through the point R is expressed as:

$$i_2 = i_{A1} - i_{T1}$$

$$i_2' = i_{B} - i_{B1}$$

$$i_R = i_2' - i_2 = i_{B} - i_{B1} - i_{A1} + i_{T1}' \qquad (8)$$

In either case, the current $i_Q$ or $i_R$ is expressed as the operations of the observable values. This holds in other busbar sections between the neighbouring line outlets.

Category (3)

This category is dealt with in the same way as one where a fault has occurred on the X busbar or the Y busbar. If a fault has occurred on the X busbar end, the currents, $i_{A1P}$, $i_Q$ and $i_R$ of the points of the aforementioned categories (1) and (2) are nearly zero, and in addition, if the current $i_N$ of the following equation (9) exceeds a predetermined threshold, then it is considered that the fault has occurred on either of the busbar ends.

$$i_N = i_{A1} + i_{T1} + i_{B1} + i_B \qquad (9)$$

However, it is difficult by this method to particularly localise the faulty point to the busbar end X1 and the neighbouring section thereof or to the busbar end X2 and the neighbouring section thereof. This does not practically matter, since these sections are limited. Moreover, it is possible to configure the busbars so that they have no ends. In this case, it is not necessary to consider category (3).

In the aforementioned description, categories (1), (2) and (3) are described separately. However, it is a general practice to integrate these categories in order to detect the fault and to thus protect the busbar with the protecting relays. In the aforementioned description, the present invention is described as for the case of duplicated busbars, but it is also applicable to the case of a single busbar or a ring busbar.

The aforementioned description is based on Figure 3 as an alternative to Figure 2. Considering that the fault may occur in any of the busbar sections to which the voltage is applied, it is necessary to adequately deal with the sections to which categories (1), (2) and (3) are not applicable, so that it is necessary to examine Figure 2 and not the abstract thereof in detail.

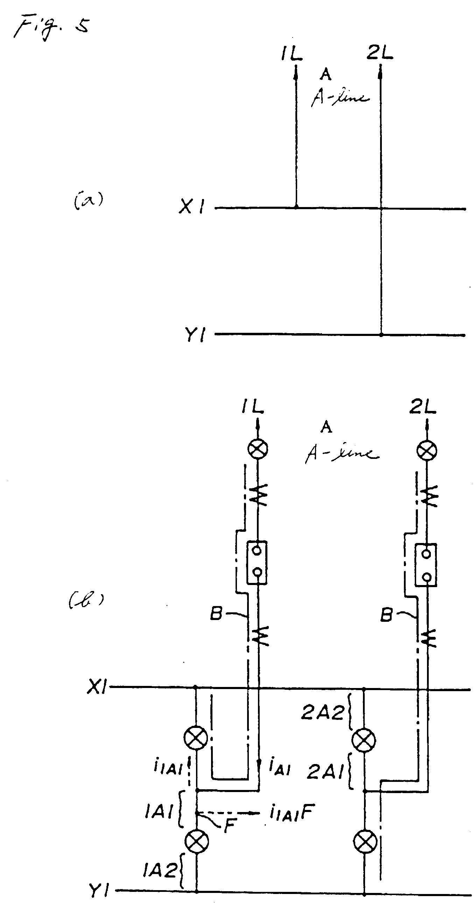

Figure 5 is a connection diagram showing a part of the A-line 1L and 2L in Figure 2, and particularly relating to Figure 4. Figure 5a shows the part of the A-line 1L and 2L in Figure 4, and Figure 5b shows the portion of the A-line 1L and 2L. As can be seen in this Figure, the section with the chained line B in Figure 5b is dealt with in Figure 4.

In this Figure, the sections 1A1, 1A2, 2A1 and 2A2 are the ones to which the electric power is not supplied but the voltage is applied.

As can be seen in the Figure, the sections 1A2 and 2A2 can be dealt with collectively with the busbars connected thereto, and thus be included in category (2). The sections 1A1 and 2A1, however, are not included in the aforementioned category (2), and so the method proceeds as the following.

If it is assumed for example in Figure 5b that a fault has occurred on the point F, the current $i_{1A1}F$ flows. If the current $i_{1A1}$ (dotted line) is assumed in the Figure, the relation is expressed as the following equation.

$$i_{1A1}F + i_{1A1} = i_{A1} \qquad (10)$$

The current $i_{A1}$ is expressed with the same equation as the current $i_{1A1}'$ in Figure 1, and using the equation (4) then $i_{1A1}F$ can be expressed as follows:

$$i_{1A1}F = i_{A1} - i_{1A1} = i_{A1} - (i_{T1} + i_B - i_{B1})$$

$$= i_{A1} - i_{T1} - i_B + i_{B1} \qquad (11)$$

Thus, the current $i_{A1}F$ can be expressed in terms of some of the observable values $i_{A1}$, $i_{A2}$, $i_{B1}$, $i_{B2}$, $i_{T1}$, $i_{T2}$ and $i_B$ and this indicates that the fault on the point F is included in the section 1A1.

When the fault has not occurred on the point F, the current $i_{1A1}F$ is zero. If the current $i_{1A1}F$ is not zero, then it indicates that the fault has occurred on the point F, thus localising the fault to point F in the section 1A1.

The present invention sets a predetermined value K1 for the current $i_{1A1}$ on the point F:

$$i_{1A1} > K1 \qquad (12)$$

If the $i_{1A1}F$ exceeds the K1, then it is possible to determine that the fault has occurred in the section 1A1 in Figure 5b. If the point F is assumed, for instance, to be in the section 2A1 or elsewhere in another section of the interlinks, it is also possible to judge the fault occurrence in the same way. In detecting the fault on the single or duplicated busbar system, the present invention provides a more fine busbar protection method, which enables the faulty point to be localised to a specific section of the busbar, and is thus more efficient than the conventional one.

**Claims**

1. A method of detecting and localising a fault in a busbar (X,Y) to which a plurality of lines or apparatus (A,B) are connected, on the basis of the currents detected by a current detector (CT) installed in the busbar and respective ones (BCT) installed in the lines or apparatus, characterised in that said method comprises the steps of;

   a) computing a first value of current flowing at the junction of the line and the busbar using the current detected by the current detector installed in the busbar;
   b) computing a second value of the current at the junction of the line and the busbar from the currents detected by the current detectors installed in the lines;
   c) calculating the difference of the first and second computed values;
   d) comparing the difference with a predetermined threshold value; and
   e) determining that a fault exists at the point if the difference exceeds the threshold value.

2. The method according to claim 1, wherein a busbar has two lines (A,B) connected thereto, characterised in that a first value of current at a point on the busbar between the connection points of the lines (A,B) is computed from currents detected in the busbar and in one of the lines (A), and a second value of current at a point on the busbar between the connection points of the lines is computed from currents detected in the busbar and in the other lines (B), and in that if the difference exceeds the threshold value, a fault is determined to exist on the busbar between the connection points of the lines.

3. The method according to claim 2, wherein;

   a) a first value of current at the junction of a first one of the lines and the busbar is computed from currents detected in the busbar and the second line, a second value of current at the junction of the first line and the busbar is computed from the current detected in the first line, the difference of the first and second computed values being compared to a threshold value;
   b) a third value of current at a point on the busbar between the connection points of the first and second lines is computed from currents detected in the busbar and the first line, a fourth value of current at a point on the busbar between the connection points of the first and second lines is computed from currents detected in the busbar and in the second line, the difference of the third and fourth computed values being compared to a threshold value;
   c) wherein if the differences do not exceed the threshold values, the operational sum of the currents flowing into or flowing out from the busbar excluding the end of the busbar is computed and compared with a predetermined limit value; and
   d) determining that, if the foregoing current sum exceeds the predetermined limit value, the fault has occurred on the end section of the busbar.

4. The method according to any of the claims 1 to 3, wherein the busbar belongs to a duplicated busbar system to each busbar of which a line or apparatus is connected via a line switch; the method characterised in that the current detectors for computing the current value are selected according to information on the switching state of the line switches.

5. The method according to any of the claims 1 to 4, wherein the busbar belongs to a single busbar system.

6. The method according to claim 4, wherein a first (X) busbar and a second (Y) busbar are connected to a line (A) at a connection point (S), via a line switch LX-A and a line switch LY-A respectively, the line switch LX-A being closed and the line switch LY-A being open; characterised by

   firstly computing the current flowing through the line switch LX-A from the current detected by the current detector;
   secondly computing the current difference between the current flowing through the line switch LX-A and the current detected by a current detector installed in the line or apparatus A;

comparing the current difference with a predetermined value;

and consequently judging in particular that, if the foregoing current difference exceeds a predetermined value, the fault has occurred on the section between the connection point S and the line switch LY-A.

**Patentansprüche**

1. Verfahren zum Erfassen und Lokalisieren eines Fehlers in einer Sammelschiene (X, Y), an welche eine Vielzahl von Leitungen oder Geräte (A, B) angeschlossen sind, auf der Basis der Ströme, welche von einem in der Sammelschiene installierten Stromdetektor (CT) und solchen (BCT) in den Leitungen oder Geräten installierten erfaßt wurden, **dadurch gekennzeichnet**, daß das Verfahren umfaßt die Schritte des

a) Errechnens eines ersten Werts des Stroms, welcher vom in die Sammelschiene installierten Stromdetektor erfaßt wurde,

b) Errechnens eines zweiten Werts des Stroms an der Verbindung der Leitung und der Sammelschiene von den Strömen, die von den in die Leitungen installierten Stromdetektoren erfaßt wurden,

c) Errechnens der Differenz der ersten und zweiten errechneten Werte,

d) Vergleichs der Differenz mit einem vorgegebenen Schwellwert und

e) Bestimmens, daß ein Fehler am Punkt existiert, falls die Differenz den Schwellwert übersteigt.

2. Verfahren nach Anspruch 1, bei dem eine Sammelschiene zwei daran angeschlossene Leitungen (A, B) aufweist, **dadurch gekennzeichnet**, daß ein erster Wert des Stroms an einem Punkt der Sammelschiene zwischen den Anschlußpunkten der Leitungen (A, B) von in der Sammelschiene und in einer der Leitungen (A) erfaßten Ströme errechnet wird, und ein zweiter Wert des Stroms an einem Punkt an der Sammelschiene zwischen den Anschlußpunkten der Leitungen von in der Sammelschiene und in der anderen Leitung (B) erfaßten Ströme errechnet wird und daß, falls die Differenz den Schwellwert übersteigt, das Vorhandensein eines Fehlers an der Sammelschiene zwischen den Anschlußpunkten der Leitungen bestimmt wird.

3. Verfahren nach Anspruch 2, bei dem

a) ein erster Wert des Stroms an der Verbindung einer ersten der Leitungen und der Sammelschiene von Strömen errechnet wird, die in der Sammelschiene und der zweiten Leitung erfaßt wurden, ein zweiter Wert des Stroms an der Verbindung der ersten Leitung und der Sammelschiene vom Strom errechnet wird, der in der ersten Leitung erfaßt wurde, die Differenz der ersten und zweiten errechneten Werte mit einem Schwellwert verglichen wird,

b) ein dritter Wert des Stroms an einem Punkt an der Sammelschiene zwischen den Anschlußpunkten der ersten und zweiten Leitungen von Strömen errechnet wird, welche in der Sammelschiene und der ersten Leitung erfaßt wurden, ein vierter Wert des Stroms an einem Punkt an der Sammelschiene zwischen den Anschlußpunkten der ersten und zweiten Leitungen von Strömen errechnet wird, die in der Sammelschiene und der zweiten Leitung erfaßt wurden, die Differenz der dritten und vierten errechneten Werte mit einem Schwellwert verglichen wird,

c) wobei, falls die Differenzen den Schwellwert nicht übersteigen, die Operationssumme der Ströme, die zur oder von der Sammelschiene fließen, mit Ausnahme des Endes der Sammelschiene, errechnet wird und mit einem vorgegebenen Grenzwert verglichen wird und

d) bestimmt wird, daß, falls die vorherige Stromsumme den vorbestimmten Grenzwert übersteigt, der Fehler im Endabschnitt der Sammelschiene aufgetreten ist.

4. Verfahren nach einem der Ansprüche 1 bis 3, **dadurch gekennzeichnet**, daß die Sammelschiene zu einem Doppelsammelschienensystem gehört, bei dem an jede Sammelschiene eine Leitung oder ein Gerät über einen Leitungsschalter angeschlossen ist, wobei das Verfahren dadurch gekennzeichnet ist, daß die Stromdetektoren zur Errechnung des Stromwerts gemäß der Information des Schaltzustands der Leitungsschalter ausgewählt werden.

5. Verfahren nach einem der Ansprüche 1 bis 4, bei dem die Sammelschiene zu einem einzigen Sammelschienensystem gehört.

6. Verfahren nach Anspruch 4, bei dem eine erste Sammelschiene (X) und eine zweite Sammelschiene (Y) mit einer Leitung (A) an einem Anschlußpunkt (S) über einen Leitungsschalter LX-A und einen Leitungsschalter LY-A an geschlossen sind, der Leitungsschalter LX-A geschlossen und der Leitungsschalter LY-A geöffnet ist, **dadurch gekennzeichnet**, daß erstens der durch den Leitungsschalter LX-A fließende Strom vom Strom errechnet wird, der durch den Stromdetektor erfaßt wurde, zweitens die Stromdifferenz zwischen dem durch den Leitungsschalter LX-A fließenden Strom und dem Strom errechnet wird, der von in der Leitung oder dem Gerät A installierten Stromdetektor erfaßt wurde, die Stromdifferenz mit einem vorgegebenen Wert verglichen wird und demzufolge im speziellen beurteilt wird, falls die vorgenannte Stromdifferenz den vorgegebenen Wert übersteigt, daß der Fehler in einem Abschnitt zwischen dem Verbindungspunkt S und dem Leitungsschalter LY-A aufgetreten ist.

**Revendications**

1. Procédé de détection et de localisation d'un défaut dans une barre bus (X, Y) à laquelle est reliée une pluralité de lignes ou d'appareils (A, B), sur la base des courants détectés par un détecteur (CT) de courant installé dans la barre bus et par des détecteurs respectifs (BCT) installés sur les lignes ou dans les appareils, ledit procédé étant caractérisé en ce qu'il comprend les étapes consistant à:

   a) calculer une première intensité du courant circulant à la jonction de la ligne et de la barre bus à l'aide du courant détecté par le détecteur de courant installé dans la barre bus;
   b) calculer une deuxième intensité du courant à la jonction de la ligne et de la barre bus à partir des courants détectés par les détecteurs de courant installés sur les lignes;
   c) calculer la différence entre la première et la deuxième valeurs calculées;
   d) comparer la différence avec une valeur de seuil prédéterminée; et
   e) déterminer qu'un défaut existe au niveau du point si la différence dépasse la valeur de seuil.

2. Procédé selon la revendication 1, dans lequel deux lignes (A, B) sont reliées à une barre bus, caractérisé en ce qu'une première intensité de courant en un point de la barre bus situé entre les points de raccordement des lignes (A, B) est calculée d'après des courants détectés dans la barre bus et sur une des lignes (A), et une deuxième intensité de courant en un point de la barre bus situé entre les points de raccordement des lignes est calculée d'après des courants détectés dans la barre bus et sur les autres lignes (B), et en ce que si la différence dépasse la valeur de seuil, il est déterminé qu'un défaut existe dans la barre bus entre les points de raccordement des lignes.

3. Procédé selon la revendication 2, dans lequel:

   a) une première intensité de courant à la jonction d'une première des lignes et de la barre bus est calculée d'après des courants détectés dans la barre bus et sur la deuxième ligne, une deuxième intensité de courant à la jonction de la première ligne et de la barre bus est calculée d'après le courant détecté sur la première ligne, la différence entre les première et deuxième intensités calculées étant comparée avec une valeur de seuil;
   b) une troisième intensité de courant en un point de la barre bus situé entre les points de raccordement des première et deuxième lignes est calculée d'après des courants détectés dans la barre bus et sur la première ligne, une quatrième intensité de courant en un point de barre bus situé entre les points de raccordement des première et deuxième lignes est calculée d'après des courants détectés dans la barre bus et sur la deuxième ligne, la différence entre les troisième et quatrième valeurs calculées étant comparée avec une valeur de seuil;
   c) si les différences ne dépassent pas les valeurs de seuil, la somme opératoire des courants pénétrant dans la barre bus ou sortant de celle-ci, à l'exclusion de l'extrémité de la barre bus, est calculée et comparée avec une valeur limite prédéterminée; et
   d) on détermine que, si la somme précitée des intensités dépasse la valeur limite prédéterminée, le défaut est survenu dans la partie formant extrémité de la barre bus.

4. Procédé selon l'une quelconque des revendications 1 à 3, dans lequel la barre bus appartient à un système double de barre bus à chaque barre bus duquel une ligne ou un appareil sont reliés par d'intermédiaire d'un commutateur de ligne, le procédé étant caractérisé en ce que les détecteurs de courant servant à calculer l'intensité du courant sont sélectionnés en fonction d'informations sur l'état de commutation des commutateurs de ligne.

5. Procédé selon l'une quelconque des revendications 1 à 4, dans lequel la barre bus appartient à un seul système de barre bus.

6. Procédé selon la revendication 4, dans lequel une première (X) barre bus et une deuxième (Y) barre bus sont reliées à une ligne (A) en un point de connexion (S), respectivement par l'intermédiaire d'un commutateur LX-A de ligne et d'un commutateur LY-A de ligne, le commutateur LX-A de ligne étant fermé et le commutateur LY-A de ligne étant ouvert; caractérisé par les étapes consistant, premièrement, à calculer l'intensité du courant traversant le commutateur LX-A de ligne d'après le courant détecté par le détecteur de courant; deuxièmement, calculer la différence d'intensité entre le courant traversant le commutateur LX-A de ligne et le courant détecté par un détecteur de courant installé sur la ligne ou dans l'appareil A; comparer la différence d'intensité avec une valeur prédéterminée; et, par conséquent, juger en particulier que si la différence précitée d'intensité depasse une valeur prédéterminée, le défaut s'est produit dans la partie située entre le point de raccordement S et le commutateur LY-A de ligne.

Fig. 1

Fig. 2

A - line                                                                 B - line

A                                                    B

1L        2L                                    1L        2L

BCT-A1  BCT-A2                          BCT-B1  BCT-B2

CB-A1   CB-A2            X              CB-B1   CB-T2                      PD

LCT-A1  LCT-A2                          LCT-B1  LCT-B2

                                                                    LX-B

LX-A1  LX-A2  LX-T1  LX-T2  LX-B1  LX-B2

                                                                    LY-B

LY-A1  LY-A2  LY-T1  LY-T2  LY-B1  LY-B2

            TCT-T1  TCT-T2            CT-X

            CB-T1   CB-T2      Y      CB-B                                PD

            BCT-T1  BCT-T2            CT-Y

            1B      2B

            BCT-T11 BCT-T21

            CB-T11  CB-T21

            TCT-T11 TCT-T11

Fig. 3

Fig. 4

Trip signal to CB

Fig. 5

(a)

(b)